# EUROPEAN PATENT APPLICATION

(11) **EP 4 331 758 A1**
(43) Date of publication of application: **06.03.2024**
(21) Application number: 22795286.8
(22) Date of filing: 04.03.2022
(51) Int. Cl.: B23B 27/14, B23P 15/28, C23C 16/36, C23C 16/455, C23C 28/04, C23C 28/00, C23C 30/00

(54) **CUTTING TOOL AND METHOD FOR MANUFACTURING SAME**

(30) Priority: 30.04.2021 JP 2021078030
(71) Applicant: Sumitomo Electric Industries, Ltd., Osaka-shi, Osaka 541-0041 (JP)
(72) Inventor: PASEUTH, Anongsack, Osaka-shi, Osaka 541-0041 (JP); ONO, Satoshi, Osaka-shi, Osaka 541-0041 (JP); OKAMURA, Katsumi, Osaka-shi, Osaka 541-0041 (JP); KURAMOCHI, Koji, Osaka-shi, Osaka 541-0041 (JP)
(74) Representative: Boult Wade Tennant LLP
(86) International application number: PCT/JP2022/009464
(87) International publication number: WO 2022/230363

(57) **Abstract**

A cutting tool comprising a base material and a coating disposed on the base material, wherein the coating comprises a hard particle layer formed from a hard particle, the hard particle comprises a multilayer structure in which a first unit layer and a second unit layer are alternately stacked, the first unit layer is formed from a first compound having a cubic crystal structure, the second unit layer is formed from a second compound having a cubic crystal structure, each of the first compound and the second compound consists of one or more metal elements selected from the group consisting of a periodic table group 4 element, a periodic table group 5 element, and a periodic table group 6 element, silicon, and one or more elements selected from the group consisting of carbon, nitrogen, boron, and oxygen, and a percentage of the number of atoms of the silicon to a sum of the numbers of atoms of the metal element and the silicon in the first unit layer is different from a percentage of the number of atoms of the silicon to a sum of the numbers of atoms of the metal element and the silicon in the second unit layer.

## Description

### TECHNICAL FIELD

The present disclosure relates to a cutting tool and a method for manufacturing the same. The present application claims priority from Japanese Patent Application No. 2021-078030 filed on April 30, 2021. All descriptions provided in the Japanese patent application are incorporated herein by reference.

### BACKGROUND ART

Conventionally, in order to improve the wear resistance of a cutting tool, a cutting tool having a TiSiCN film formed on a base material has been developed.

PTL 1 discloses a nanocomposite coating comprising a nanocrystalline layer of TiCₓN₁₋ₓ manufactured by a thermal CVD and a second phase of amorphous SiCₓN_{y}.

PTL 2 discloses at least one nanocomposite layer including a first nanocrystalline phase formed from cubic titanium oxycarbonitride manufactured by a thermal CVD method and a second amorphous phase formed from silicon oxycarbonitride or silicon oxycarbide.

NPL 1 discloses a TiSiCN coating having a nanocomposite structure formed by a PVD method.

### CITATION LIST

### PATENT LITERATURE

PTL 1: Japanese National Patent Publication No. 2015-505902
PTL 2: Japanese National Patent Publication No. 2020-507679

### NON PATENT LITERATURE

NPL 1: Shinya Imamura et al., "Properties and cutting performance of AlTiCrN/TiSiCN bilayer coatings deposited by cathodic-arc ion plating", Surface and Coatings Technology, 202, (2007), 820-825

### SUMMARY OF INVENTION

The cutting tool of the present disclosure is
a cutting tool comprising a base material and a coating disposed on the base material, wherein
the coating comprises a hard particle layer formed from a hard particle,
the hard particle comprises a multilayer structure in which a first unit layer and a second unit layer are alternately stacked,
the first unit layer is formed from a first compound having a cubic crystal structure, the second unit layer is formed from a second compound having a cubic crystal structure,
each of the first compound and the second compound consists of
   one or more metal elements selected from the group consisting of a periodic table group 4 element, a periodic table group 5 element, and a periodic table group 6 element,
   silicon, and
   one or more elements selected from the group consisting of carbon, nitrogen, boron, and oxygen, and
a percentage of the number of atoms of the silicon to a sum of the numbers of atoms of the metal element and the silicon in the first unit layer is different from a percentage of the number of atoms of the silicon to a sum of the numbers of atoms of the metal element and the silicon in the second unit layer.

The method for manufacturing the cutting tool of the present disclosure is
a method for manufacturing the above cutting tool, the method comprising a first step of preparing a base material, and
a second step of forming a coating on the base material to obtain a cutting tool, wherein the second step comprises a 2a-th step of forming a hard particle layer formed from a hard particle by a CVD method,
the 2a-th step comprises a 2a-1-th step of ejecting a first raw material gas, a second raw material gas, and a third raw material gas toward a surface of the base material,
the first raw material gas comprises one or more elements selected from the group consisting of a periodic table group 4 element, a periodic table group 5 element, and a periodic table group 6 element,
the second raw material gas is SiCl₄,
the third raw material gas comprises one or more elements selected from the group consisting of carbon, nitrogen, boron, and oxygen,
the first raw material gas is ejected from a plurality of first jet holes provided in a nozzle,
the second raw material gas is ejected from a plurality of second jet holes provided in the nozzle,
the third raw material gas is ejected from a plurality of third jet holes provided in the nozzle,
in the 2a-1-th step, the nozzle rotates,
the plurality of second jet holes comprise a 2-1-th jet hole and a 2-2-th jet hole, and a diameter r1 of the 2-1-th jet hole is different from a diameter r2 of the 2-2-th jet hole.

### BRIEF DESCRIPTION OF DRAWINGS

Fig. 1 is a schematic diagram showing one example of a cross section of a cutting tool according to Embodiment 1.
Fig. 2 is a schematic diagram showing a different example of the cross section of the cutting tool according to Embodiment 1.
Fig. 3 is a schematic diagram showing a different example of the cross section of the cutting tool according to Embodiment 1.
Fig. 4 is a schematic diagram showing a different example of the cross section of the cutting tool according to Embodiment 1.
Fig. 5 is a bright-field scanning electron microscope (BF-SEM) image of a cross section of a hard phase particle layer of the cutting tool according to Embodiment 1.
Fig. 6 is an electron diffraction image photographed in a region A shown in Fig. 5.
Fig. 7 is a graph showing changes in the percentage of the number of atoms of silicon, A_{Si}, to the sum of the number of atoms of a metal element (titanium), A_{M}, and the number of atoms of silicon, A_{Si}, {Asi/(Asi + A_{M})} × 100, along the arrow direction shown in Fig. 5.
Fig. 8 is a Fourier transform image obtained by carrying out a Fourier transform on region A shown in Fig. 5.
Fig. 9 is a graph showing an intensity profile within a rectangular frame of the Fourier transform image of Fig. 8.
Fig. 10 is a schematic cross-sectional view of one example of a CVD apparatus used for manufacturing a cutting tool according to Embodiment 2.

### DETAILED DESCRIPTION

### [Problem to be Solved by the Present Disclosure]

In recent years, there has been an ever-increasing demand for improving the tool life, and further improvement in tool life has been demanded, particularly even in milling working of high-hardness and heat-resistant stainless steel.

Accordingly, an object of the present disclosure is to provide a cutting tool that can have a long tool life even in milling working of high-hardness and heat-resistant stainless steel.

### [Advantageous Effect of the Present Disclosure]

According to the present disclosure, it is possible to provide a cutting tool that can have a long tool life even in milling working of high-hardness and heat-resistant stainless steel.

### [Description of Embodiments]

First, aspects of the present disclosure will be listed and described.
(1) The cutting tool of the present disclosure is
   a cutting tool comprising a base material and a coating disposed on the base material, wherein
   the coating comprises a hard particle layer formed from a hard particle,
   the hard particle comprises a multilayer structure in which a first unit layer and a second unit layer are alternately stacked,
   the first unit layer is formed from a first compound having a cubic crystal structure,
   the second unit layer is formed from a second compound having a cubic crystal structure,
   each of the first compound and the second compound consists of
      one or more metal elements selected from the group consisting of a periodic table group 4 element, a periodic table group 5 element, and a periodic table group 6 element,
      silicon, and
      one or more elements selected from the group consisting of carbon, nitrogen, boron, and oxygen, and
   a percentage of the number of atoms of the silicon to a sum of the numbers of atoms of the metal element and the silicon in the first unit layer is different from a percentage of the number of atoms of the silicon to a sum of the numbers of atoms of the metal element and the silicon in the second unit layer.

According to the present disclosure, it is possible to provide a cutting tool that can have a long tool life even in milling working of high-hardness and heat-resistant stainless steel.

(2) The first unit layer and the second unit layer preferably have the same crystal orientation. According to this, it is possible to minimize the interfacial energy, and the hardness is unlikely to decrease even in exposure to a high-temperature environment.

(3) In each of the first unit layer and the second unit layer, the percentage of the number of atoms of the silicon to the sum of the numbers of atoms of the metal element and the silicon is preferably 0.5% or more and 10% or less. According to this, the thermal crack resistance of the coating and the close adhesion between the hard particle layer and an adjacent layer are improved in a well-balanced manner.

(4) Preferably, the thickness of the hard particle layer is 3 µm or more and 15 µm or less, and
the thickness of the hard coating layer is 3 µm or more and 30 µm or less.

According to this, the wear resistance and the breakage resistance of the coating are improved in a well-balanced manner.

(5) The difference between the percentage of the number of atoms of the silicon, A_{Si}, to the sum of the number of atoms of the metal element, A_{M}, and the number of atoms of the silicon, A_{Si}, {Asi/(Asi + A_{M})} × 100, in the first unit layer and the percentage of the number of atoms of the silicon, A_{Si}, to the sum of the number of atoms of the metal element, A_{M}, and the number of atoms of the silicon, A_{Si}, {Asi/(Asi + A_{M})} × 100, in the second unit layer is preferably 0.5% or more and 10% or less. According to this, the hardness of the coating is improved.

(6) Preferably, the coating comprises a base layer disposed between the base material and the hard particle layer,
the base layer is formed from a third compound, and
the third compound consists of
   one or more elements selected from the group consisting of a periodic table group 4 element, a periodic table group 5 element, a periodic table group 6 element, and aluminum, and
   one or more elements selected from the group consisting of carbon, nitrogen, boron, and oxygen.

According to this, the close adhesion between the coating and the base material is improved, and the wear resistance is also improved.

(7) Preferably, the coating comprises a base layer disposed directly on the base material, and
the base layer consists of at least one selected from the group consisting of a TiN layer, a TiC layer, a TiCN layer, a TiBN layer, and an Al₂O₃ layer.

By disposing a TiN layer, a TiC layer, a TiCN layer, or a TiBN layer directly on the base material as the base layer, the close adhesion between the base material and the coating can be enhanced. In addition, by using an Al₂O₃ layer as the base layer, the oxidation resistance of the coating can be enhanced.

(8) Preferably, the coating comprises a surface layer disposed on a topmost surface thereof,
the surface layer is formed from a fourth compound, and
the fourth compound consists of
   one or more elements selected from the group consisting of a periodic table group 4 element, a periodic table group 5 element, a periodic table group 6 element, and aluminum, and
   one or more elements selected from the group consisting of carbon, nitrogen, boron, and oxygen.

According to this, the thermal crack resistance and the wear resistance of the coating are improved.

(9) The coating preferably comprises an intermediate layer disposed between the base layer and the hard particle. According to this, the wear resistance of the coating is improved.

(10) The method for manufacturing the cutting tool of the present disclosure is
a method for manufacturing the above cutting tool, the method comprising
a first step of preparing a base material, and
a second step of forming a coating on the base material to obtain a cutting tool, wherein the second step comprises a 2a-th step of forming a hard particle layer formed from a hard particle by a CVD method,
the 2a-th step comprises a 2a-1-th step of ejecting a first raw material gas, a second raw material gas, and a third raw material gas toward a surface of the base material,
the first raw material gas comprises one or more elements selected from the group consisting of a periodic table group 4 element, a periodic table group 5 element, and a periodic table group 6 element,
the second raw material gas is SiCl₄,
the third raw material gas comprises one or more elements selected from the group consisting of carbon, nitrogen, boron, and oxygen,
the first raw material gas is ejected from a plurality of first jet holes provided in a nozzle,
the second raw material gas is ejected from a plurality of second jet holes provided in the nozzle,
the third raw material gas is ejected from a plurality of third jet holes provided in the nozzle,
in the 2a-1-th step, the nozzle rotates,
the plurality of second jet holes comprise a 2-1-th jet hole and a 2-2-th jet hole, and
a diameter r1 of the 2-1-th jet hole is different from a diameter r2 of the 2-2-th jet hole.

According to the present disclosure, it is possible to provide a cutting tool that can have a long tool life even in milling working of high-hardness and heat-resistant stainless steel.

### [Details of the embodiments of the present disclosure]

In order to develop a cutting tool that has a long tool life even in milling working of high-hardness and heat-resistant stainless steel, the present inventors milling-worked high-hardness and heat-resistant stainless steel with a conventional cutting tool and observed the state of damage to the tool.

When high-hardness and heat-resistant stainless steel was milling-worked by using the tools of PTL 1 and PTL 2, it was confirmed that a thermal crack caused by a thermal load during cutting working propagated at the interface between the nanocomposite coating or the nanocomposite layer and the base layer, and peeling of the interface occurred. It is presumed that this is due to insufficient matching of the interface between the base layer having crystallinity and the nanocomposite coating or the nanocomposite layer.

When high-hardness and heat-resistant stainless steel was milling-worked by using the tool of NPL 1, self-destruction of the TiSiCN coating was confirmed. It is presumed that this is because the TiSiCN coating is formed by a PVD method, and thus the compressive residual stress of the TiSiCN coating is large.

Based on the above findings, the present inventors have carried out intensive studies and as a result, have obtained a cutting tool that has a long tool life even in milling working of high-hardness and heat-resistant stainless steel. With reference to the drawings, specific examples of the cutting tool and the method for manufacturing the same according to the present disclosure will be described below. In the drawings of the present disclosure, the same reference signs represent the same portions or equivalent portions. In addition, a dimensional relationship such as length, width, thickness, or depth is appropriately changed for clarity and simplification of the drawings, and does not necessarily represent an actual dimensional relationship.

As used herein, the expression of a range in the format "A to B" means the upper limit and the lower limit of the range (that is, A or more and B or less), and when no unit is written in A and a unit is only written in B, the unit for A and the unit for B are the same.

As used herein, when a compound or the like is represented by a chemical formula, if the atomic ratio is not particularly limited, the chemical formula shall include all conventionally known atomic ratios, and should not necessarily be limited only to those within the stoichiometric range. For example, when "TiSiCN" is provided, the ratio of the numbers of atoms constituting TiSiCN includes all conventionally known atomic ratios.

As used in the present disclosure, when one or more numerical values are written as each of the lower limit and the upper limit of a numerical range, a combination of any one numerical value written as the lower limit and any one numerical value written as the upper limit shall also be disclosed. For example, when a1 or more, b1 or more, and c1 or more are written as the lower limit, and a2 or less, b2 or less, and c2 or less are written as the upper limit, a1 or more and a2 or less, a1 or more and b2 or less, a1 or more and c2 or less, b1 or more and a2 or less, b1 or more and b2 or less, b1 or more and c2 or less, c1 or more and a2 or less, c1 or more and b2 or less, and c1 or more and c2 or less shall be disclosed.

### [Embodiment 1: Cutting Tool]

The cutting tool of one embodiment of the present disclosure (hereinafter also referred to as "the present embodiment") is
a cutting tool comprising a base material and a coating disposed on the base material, wherein
the coating comprises a hard particle layer formed from a hard particle,
the hard particle comprises a multilayer structure in which a first unit layer and a second unit layer are alternately stacked,
the first unit layer is formed from a first compound having a cubic crystal structure, the second unit layer is formed from a second compound having a cubic crystal structure,
each of the first compound and the second compound consists of
   one or more metal elements selected from the group consisting of a periodic table group 4 element, a periodic table group 5 element, and a periodic table group 6 element,
   silicon, and
   one or more elements selected from the group consisting of carbon, nitrogen, boron and oxygen, and
a percentage of the number of atoms of the silicon to a sum of the numbers of atoms of the metal element and the silicon in the first unit layer is different from a percentage of the number of atoms of the silicon to a sum of the numbers of atoms of the metal element and the silicon in the second unit layer.

As used herein, the periodic table group 4 element includes titanium (Ti), zirconium (Zr), and hafnium (Hf), the periodic table group 5 element includes vanadium (V), niobium (Nb), and tantalum (Ta), and the periodic table group 6 element includes chromium (Cr), molybdenum (Mo), and tungsten (W).

The cutting tool of the present embodiment can have a long tool life even in milling working of high-hardness and heat-resistant stainless steel. The reasons for this are unclear, but are presumed to be as shown (i) to (iii) below.
(i) In the cutting tool of the present embodiment, the coating includes a hard particle layer formed from a hard particle. The hard particle layer can have a region consisting of a granular structure in the thickness direction thereof. This improves the toughness of the hard particle layer, and even if a thermal crack due to cutting occurs on the surface of the coating, propagation of the crack to the base material is effectively suppressed. In addition, even if the coating includes a different layer other than the hard particle layer, the difference in crystallinity between the hard particle layer and the different layer can be reduced, and thus propagation of a crack at the interface between the hard particle layer and the different layer is suppressed, and film peeling is suppressed. Therefore, the cutting tool can have a long tool life.
(ii) In the cutting tool of the present embodiment, the hard particle includes a multilayer structure in which a first unit layer and a second unit layer different in composition from each other are alternately stacked. According to this, even if strain occurs in the hard particle and a crack due to cutting occurs on the surface of the coating, propagation of the crack to the base material is effectively suppressed. In addition, the hardness of the hard particle and the hard particle layer is increased, and the wear resistance of the cutting tool is improved. In addition, therefore, the cutting tool can have a long tool life.
(iii) In the cutting tool of the present embodiment, each of the first compound and the second compound has a cubic crystal structure, and consists of
   one or more metal elements selected from the group consisting of a periodic table group 4 element, a periodic table group 5 element, and a periodic table group 6 element, silicon, and
   one or more elements selected from the group consisting of carbon, nitrogen, boron, and oxygen.

The first compound and the second compound have high hardness. Therefore, the hard particle layer including the first compound and the second compound has high hardness and excellent wear resistance. Therefore, the cutting tool can have a long tool life.

### < Cutting Tool>

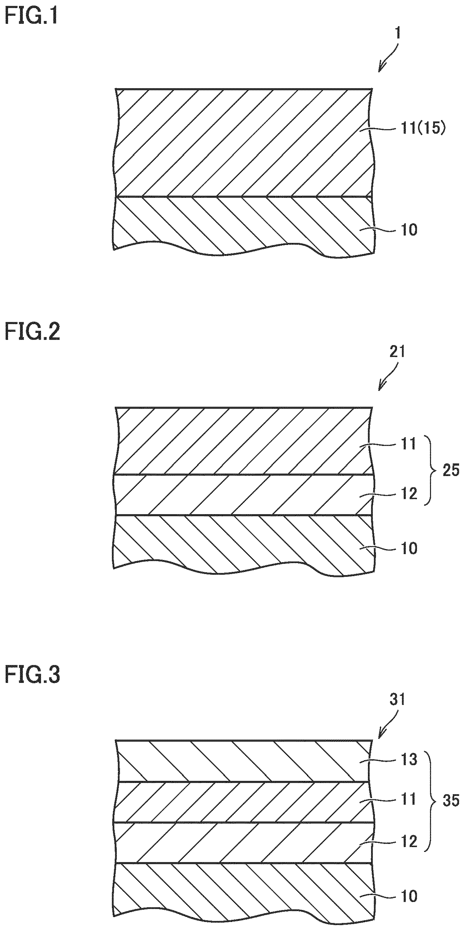

As shown in Fig. 1, a cutting tool 1 of the present embodiment includes a base material 10 and a coating 15 disposed on base material 10. Fig. 1 shows a case where coating 15 is constituted only by a hard particle layer 11. Coating 15 preferably coats at least a part of a portion of the base material involved in cutting, and more preferably coats the entire surface of the base material. The term portion of the base material involved in cutting means a region within a distance of 500 µm from the cutting edge ridgeline on the surface of the base material. Even if a part of the base material is not coated with the coating or the configuration of the coating is partially different, this does not depart from the scope of the present embodiment.

### <Type of Cutting Tool>

The cutting tool of the present disclosure can be a drill, an end mill (for example, a ball end mill), an indexable cutting insert for a drill, an indexable cutting insert for an end mill, an indexable cutting insert for milling working, an indexable cutting insert for turning working, a metal saw, a gear cutting tool, a reamer, a tap, or the like.

### <Base Material>

Base material 10 includes a rake face and a flank face, and any base material can be used as long as it is conventionally known as a base material of this type. For example, the base material is preferably any of a cemented carbide (for example, WC-base cemented carbide including tungsten carbide and cobalt, the cemented carbide can include a carbonitride of Ti, Ta, Nb, or the like), a cermet (including TiC, TiN, TiCN, or the like as a main component), high-speed steel, a ceramic (such as titanium carbide, silicon carbide, silicon nitride, aluminum nitride, or aluminum oxide), a cubic boron nitride sintered material, and a diamond sintered material.

Among these various base materials, a base material formed from a cemented carbide including tungsten carbide and cobalt wherein the content of cobalt in the cemented carbide is 6% by mass or more and 11% by mass or less is preferable. According to this, the base material has an excellent balance between hardness and strength at a high temperature, and has excellent properties as a base material for a cutting tool for the above uses. When a WC-base cemented carbide is used as the base material, the structure thereof may include free carbon, an abnormal layer referred to as an η phase or an ε phase, or the like.

Further, the base material may have the surface thereof modified. For example, in the case of a cemented carbide, a β-free layer may be formed on the surface thereof, and in the case of a cermet, a hardened surface layer may be formed. The base material exhibits the desired effect even if the surface thereof has been modified.

When the cutting tool is an indexable cutting insert or the like, the base material may or may not have a chip breaker. As the shape of the cutting edge ridgeline portion, any shape of a sharp edge (a ridge where a rake face and a flank face intersect), a honing (a shape obtained by rounding a sharp edge), a negative land (a chamfered shape), a shape obtained by combining a honing and a negative land, and the like can be adopted.

### < Coating>

### (Configuration of Coating)

The coating of the present embodiment includes a hard particle layer. The coating of the present embodiment may include a different layer as long as the coating includes a hard particle layer.

For example, as shown in a cutting tool 21 of Fig. 2, a coating 25 can include, in addition to a hard particle layer 11, a base layer 12 disposed between a base material 10 and hard particle layer 11.

As shown in a cutting tool 31 of Fig. 3, a coating 35 can include, in addition to a hard particle layer 11 and a base layer 12, a surface layer 13 disposed on hard particle layer 11.

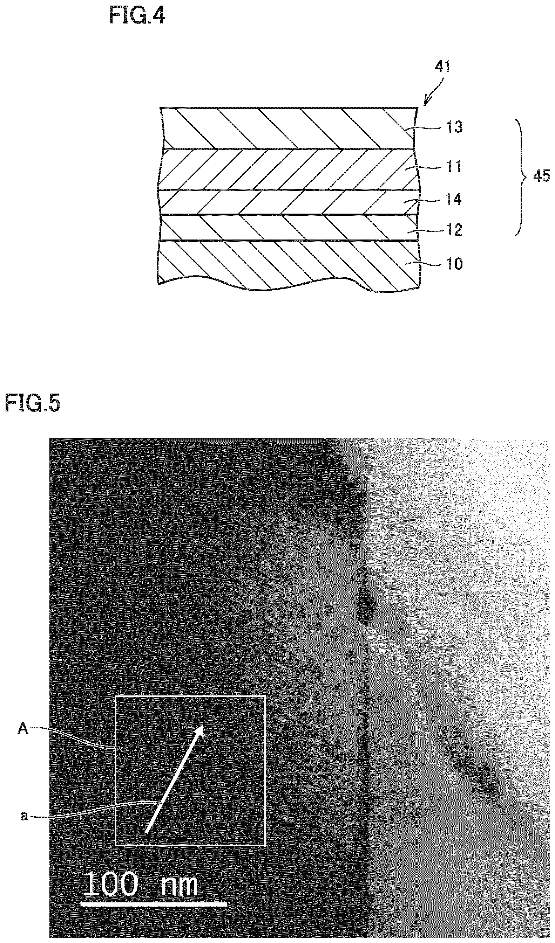

As shown in a cutting tool 41 of Fig. 4, a coating 45 can include, in addition to a hard particle layer 11, a base layer 12, and a surface layer 13, an intermediate layer 14 disposed between base layer 12 and hard particle layer 11.

The details of the hard particle layer, the base layer, the intermediate layer, and the surface layer will be described later.

### (Thickness of coating)

The thickness of the coating of the present embodiment is preferably 3 µm or more and 30 µm or less. Here, the term thickness of the coating means the thickness of the entire coating. When the thickness of the entire coating is 3 µm or more, the coating can have excellent wear resistance. On the other hand, when the thickness of the entire coating is 30 µm or less, it is possible to suppress the occurrence of peeling or destruction of the coating when a large stress is applied between the coating and the base material during cutting working. The lower limit of the thickness of the entire coating is more preferably 5 µm or more, and further preferably 10 µm or more, from the viewpoint of improving the wear resistance. The upper limit of the thickness of the entire coating is more preferably 25 µm or less, and further preferably 20 µm or less, from the viewpoint of suppressing the occurrence of peeling or destruction of the coating. The thickness of the entire coating is more preferably 5 µm or more and 25 µm or less, and further preferably 10 µm or more and 20 µm or less.

The thickness of the coating is measured, for example, by obtaining a cross-sectional sample parallel to the normal direction of the surface of the base material and observing this sample with a scanning transmission electron microscope (STEM). The cross-sectional sample is a thin sliced sample worked by using an ion slicer or the like. Examples of the scanning transmission electron microscope include JEM-2100F (trademark) manufactured by JEOL Ltd. The measurement conditions are an acceleration voltage of 200 kV and an amount of current of 0.3 nA.

As used herein, when the term "thickness" is used, the thickness means the average thickness. Specifically, the observation magnification of a cross-sectional sample is 10000 times, and a rectangular measurement field of view of (100 µm in the direction parallel to the base material surface) × (distance including the total thickness of the coating) is set on an electron microscope image, the thickness widths at 10 locations are measured in the field of view, and the average value thereof is defined as the "thickness." The thickness (average thickness) of each layer described below is also similarly measured and calculated.

It has been confirmed that as long as the measurement is carried out on the same sample, even if the measurement is carried out a plurality of times by changing the selection location of the measurement field of view, there is little variation in the measurement results, and that even if the measurement field of view is arbitrarily set, it is not contrived.

### <Hard Particle Layer>

### (Configuration of hard particle layer)

The hard particle layer of the present embodiment is formed from a hard particle, and the hard particle includes a multilayer structure in which a first unit layer and a second unit layer are alternately stacked.

Even if the hard particle layer of the present embodiment includes a configuration other than the hard particle, for example, an amorphous phase or an intermetallic compound (for example, TiSi₂ or Co₂Si) as an inevitable impurity, this does not deviate from the scope of the present disclosure as long as the effect of the present disclosure is exhibited.

### (Thickness of hard particle layer)

The thickness of the hard particle layer of the present embodiment is preferably 3 µm or more and 15 µm or less. When the thickness of the hard particle layer is 3 µm or more, the hard particle layer can have excellent wear resistance. On the other hand, when the thickness of the hard particle layer is 15 µm or less, it is possible to suppress the occurrence of peeling or destruction of the coating when a large stress is applied between the coating and the base material during cutting working. The lower limit of the thickness of the hard particle layer is more preferably 4 µm or more, and further preferably 5 µm or more, from the viewpoint of improving the wear resistance. The upper limit of the thickness of the hard particle layer is more preferably 15 µm or less, and further preferably 10 µm or less, from the viewpoint of suppressing the occurrence of peeling or destruction of the coating. The thickness of the hard particle layer is more preferably 4 µm or more and 15 µm or less, and further preferably 5 µm or more and 10 µm or less.

The first unit layer is formed from a first compound having a cubic crystal structure. The second unit layer is formed from a second compound having a cubic crystal structure. When the first compound and the second compound have a cubic crystal structure, both excellent wear resistance and high toughness can be achieved. It can be confirmed by pattern analysis of selected area electron beam diffraction that the first compound and the second compound have a cubic crystal structure.

Each of the first compound and the second compound consists of
one or more metal elements selected from the group consisting of a periodic table group 4 element, a periodic table group 5 element, and a periodic table group 6 element, silicon, and
one or more elements selected from the group consisting of carbon, nitrogen, boron, and oxygen.

Here, the composition of the first compound is different from the composition of the second compound. More specifically, the percentage of the number of atoms of silicon to the sum of the numbers of atoms of the metal element and silicon in the first compound is different from the percentage of the number of atoms of silicon to the sum of the numbers of atoms of the metal element and silicon in the second compound.

Even if the first compound and the second compound of the present embodiment include an unavoidable impurity, this does not deviate from the scope of the present disclosure as long as the effect of the present disclosure is exhibited.

Examples of each of the first compound and the second compound include TiSiC, TiSiN, TiSiCN, TiSiNO, TiSiCNO, TiSiBN, TiSiBNO, TiSiCBN, ZrSiC, ZrSiO₂, HfSiC, HfSiN, TiCrSiN, TiZrSiN, CrSiN, VSiN, ZrSiCN, ZrSiCNO, ZrSiN, NbSiC, NbSiN, and NbSiCN. Even if an unavoidable impurity is included in the first compound and the second compound, this does not depart from the scope of the present disclosure.

It is confirmed by the method described in (A1) to (A6) below that the hard particle includes a multilayer structure in which the first unit layer and the second unit layer are alternately stacked.
(A1) A cutting tool is cut out with a diamond wire along the normal line of the base material to expose a cross section of the hard particle layer. Focused ion beam working (hereinafter also referred to as "FIB working") is carried out on the exposed cross section to bring the cross section into a mirror surface state.
(A2) The FIB worked cross section is observed by using a bright-field scanning electron microscope (BF-SEM) to identify one hard particle. Next, a BE-STEM image of the one hard particle identified is obtained. Fig. 5 is a diagram showing one example of a BF-STEM image of one hard particle in the cutting tool of the present embodiment.
(A3) A measurement region (size: 100 nm × 100 nm) is set in such a way as to include a region in which 10 or more layers shown in white and 10 or more layers shown in black are stacked, on the BF-STEM image. In Fig. 5, a square region surrounded by a white frame corresponds to the measurement region.

In Fig. 5, the layers shown in black are regions having a high silicon content, and the layers shown in white are regions having a low silicon content.

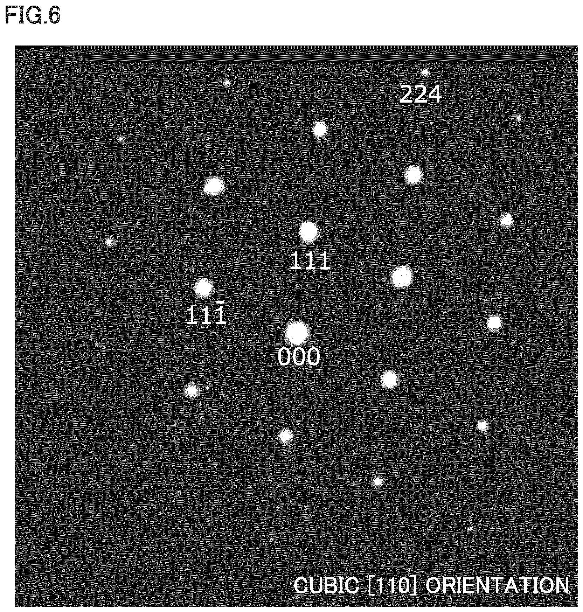

(A4) The stacking direction of the layers shown in white (hereinafter also referred to as "white layers") and the layers shown in black (hereinafter also referred to as "black layers") is identified in the measurement region on the BF-STEM image. Specifically, a selected area region electron beam diffraction pattern and the stacking direction of the white layers and the black layers are superimposed on each other to identify the stacking direction from an orientation shown by diffraction spots. An electron diffraction image photographed in region A shown in Fig. 5 is shown in Fig. 6. In Fig. 5, the stacking direction is shown by a white arrow.

(A5) In the measurement region on the BF-STEM image, line analysis is carried out along the stacking direction by EDX (Energy Dispersive X-ray Spectroscopy) attached to SEM to measure the composition. The beam diameter for line analysis is 0.5 nm or less, the scan interval is 0.5 nm, and the length of line analysis is 50 nm.

(A6) When the line analysis results satisfy (a1) and (a2) below, it is confirmed that the hard particle includes a multilayer structure in which the first unit layer and the second unit layer are alternately stacked.

(a1) The measurement region includes one or more metal elements selected from the group consisting of a periodic table group 4 element, a periodic table group 5 element, and a periodic table group 6 element, silicon, and one or more elements selected from the group consisting of carbon, nitrogen, boron, and oxygen.

(a2) A graph showing the line analysis results in a coordinate system in which the X axis represents the distance from the measurement start point, and the Y axis represents the percentage of the number of atoms of silicon, A_{Si}, to the sum of the number of atoms of the metal element, A_{M}, and the number of atoms of silicon, Asi, ({A_{Si}/(A_{Si} + A_{M})} × 100), is prepared. In the graph, the average of {Asi/(Asi + A_{M})} × 100 (hereinafter also referred to as the "average") in the measurement region is calculated. As the distance from the measurement start point increases, a region in which {Asi/(Asi + A_{M})} × 100 is larger than the average value and a region in which {Asi/(Asi + A_{M})} × 100 is smaller than the average value are alternately present.

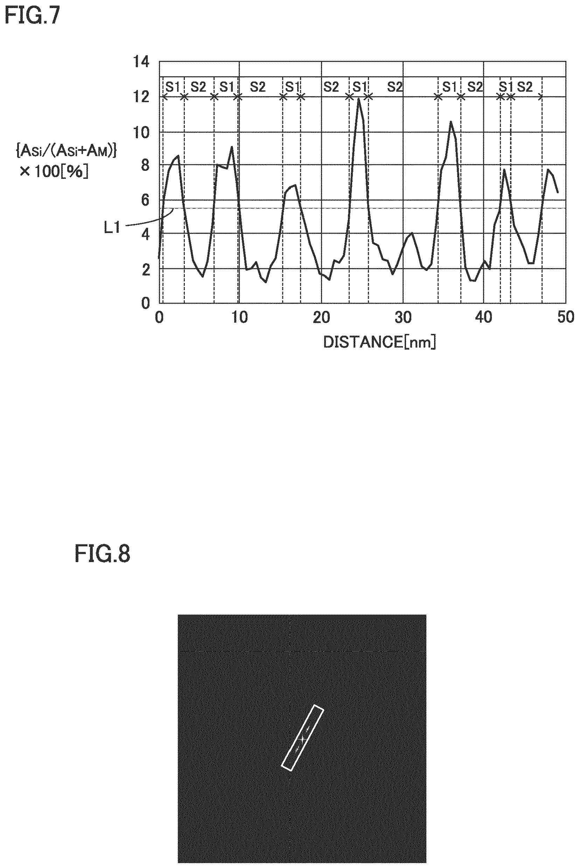

One example of the graph in the present embodiment is shown in Fig. 7. Fig. 7 is a graph showing changes in the percentage of the number of atoms of silicon, Asi, to the sum of the number of atoms of a metal element (titanium), A_{M}, and the number of atoms of silicon, A_{Si}, {Asi/(Asi + A_{M})} × 100, along the arrow direction. In Fig. 7, the X axis represents the distance along the direction of the arrow from the measurement start point, and the Y axis represents {Asi/(Asi + A_{M})} × 100. In Fig. 7, the average of {Asi/(Asi + A_{M})} × 100 in the measurement region is shown by a dotted line L1.

In Fig. 7, as the distance from the measurement start point increases, a region S1 in which {Asi/(Asi + A_{M})} × 100 is larger than the average value and a region S2 in which {Asi/(Asi + A_{M})} × 100 is smaller than the average value are alternately present. Therefore, it is confirmed that the hard particle shown in Fig. 5 includes a multilayer structure in which the first unit layer and the second unit layer are alternately stacked.

It has been confirmed that as long as the measurement is carried out on the same sample, even if the measurement is carried out a plurality of times by changing the hard particle identified in (A2) above, there is little variation in the measurement results, and that even if the measurement location is arbitrarily set, it is not contrived.

It has been confirmed by the above method that the effect of the present disclosure is exhibited as long as it is confirmed that the hard particle includes a multilayer structure in which the first unit layer and the second unit layer are alternately stacked.

Hereinafter, in order to facilitate understanding, "a region in which {Asi/(Asi + A_{M})} × 100 is larger than the average of {Asi/(Asi + A_{M})} × 100 in the measurement region" in (a2) above is also referred to as a "first unit layer," and "a region in which {Asi/(Asi + A_{M})} × 100 is smaller than the average of {Asi/(Asi + A_{M})} × 100 in the measurement region" is also referred to as a "second unit layer."

### (Composition of each of first unit layer and second unit layer)

In each of the first unit layer and the second unit layer, the percentage of the number of atoms of silicon, A_{Si}, to the sum of the number of atoms of the metal element, A_{M}, and the number of atoms of silicon, A_{Si}, {Asi/(Asi + A_{M})} × 100, is preferably 0.5% or more and 10% or less. According to this, the thermal crack resistance of the hard particle layer and the close adhesion between the hard particle layer and an adjacent layer are improved in a well-balanced manner. The lower limit of {Asi/(Asi + A_{M})} × 100 in each of the first unit layer and the second unit layer is preferably 0.5% or more, preferably 0.7% or more, preferably 1.0% or more, and preferably 1.2% or more. The upper limit of {Asi/(Asi + A_{M})} × 100 in each of the first unit layer and the second unit layer is preferably 10.0% or less, preferably 8.0% or less, preferably 7.2% or less, preferably 7% or less, and preferably 5% or less. {Asi/(Asi + A_{M})} × 100 in each of the first unit layer and the second unit layer is preferably 0.5% or more and 8.0% or less, preferably 0.5% or more and 7.2% or less, preferably 0.7% or more and 7% or less, and preferably 1.0% or more and 5.0% or less.

The lower limit of the percentage of the number of atoms of silicon, A_{Si}, to the sum of the number of atoms of the metal element, A_{M}, and the number of atoms of silicon, A_{Si}, {Asi/(Asi + A_{M})} × 100, in the first unit layer is preferably 1% or more, preferably 1.5% or more, preferably 2.0% or more, preferably 5.3% or more, and preferably 6.0% or more. The upper limit of the percentage of the number of atoms of silicon, A_{Si}, to the sum of the number of atoms of the metal element, A_{M}, and the number of atoms of silicon, A_{Si}, {Asi/(Asi + A_{M})} × 100, in the first unit layer is preferably 10.0% or less, preferably 9.0% or less, and preferably 8.0% or less. The percentage of the number of atoms of silicon, A_{Si}, to the sum of the number of atoms of the metal element, A_{M}, and the number of atoms of silicon, A_{Si}, {Asi/(Asi + A_{M})} × 100, in the first unit layer is preferably 1% or more and 10% or less, preferably 1.5% or more and 9.0% or less, preferably 2.0% or more and 8.0% or less, preferably 5.3% or more and 10.0% or less, and preferably 6.0% or more and 10.0% or less, from the viewpoint of improving the heat resistance. When the first unit layer has a configuration in which the composition changes in the thickness direction, {Asi/(Asi + A_{M})} × 100 above means the average value in the first unit layer.

The lower limit of the percentage of the number of atoms of silicon, A_{Si}, to the sum of the number of atoms of the metal element, A_{M}, and the number of atoms of silicon, A_{Si}, {Asi/(Asi + A_{M})} × 100, in the second unit layer is preferably 0.1% or more, preferably 0.2% or more, and preferably 0.5% or more. The upper limit of the percentage of the number of atoms of silicon, A_{Si}, to the sum of the number of atoms of the metal element, A_{M}, and the number of atoms of silicon, A_{Si}, {Asi/(Asi + A_{M})} × 100, in the second unit layer is preferably 2.0% or less, preferably 1.5% or less, preferably 1.2% or less, and preferably 1.0% or less. The percentage of the number of atoms of silicon, A_{Si}, to the sum of the number of atoms of the metal element, A_{M}, and the number of atoms of silicon, A_{Si}, {Asi/(Asi + A_{M})} × 100, in the second unit layer is preferably 0.1% or more and 2.0% or less, preferably 0.5% or more and 2.0% or less, preferably 0.2% or more and 1.5% or less, preferably 0.5% or more and 1.5% or less, and more preferably 0.5% or more and 1.0% or less, from the viewpoint of improving the close adhesion. When the second unit layer has a configuration in which the composition changes in the thickness direction, {Asi/(Asi + A_{M})} × 100 above means the average value in the second unit layer.

The difference between {Asi/(Asi + A_{M})} × 100 in the first unit layer and {Asi/(Asi + A_{M})} × 100 in the second unit layer is preferably 0.5% or more and 10% or less, preferably 1% or more and 9% or less, preferably 2% or more and 8% or less, and preferably 4% or more and 8% or less, from the viewpoint of improving the hardness.

The first unit layer and the second unit layer may each have a configuration consisting of a single composition in the thickness direction thereof, or a configuration in which the composition changes in the thickness direction thereof. In this case, the term {Asi/(Asi + A_{M})} × 100 in the first unit layer means the average of {Asi/(Asi + A_{M})} × 100 in the first unit layer in a region in which line analysis has been carried out. In addition, the term {Asi/(Asi + A_{M})} × 100 in the second unit layer means the average of {Asi/(Asi + A_{M})} × 100 in the second unit layer in a region in which line analysis has been carried out.

It has been confirmed that as long as the measurement is carried out on the same sample, even if the measurement is carried out a plurality of times by changing the hard particle identified in (A2) above, there is little variation in the measurement results, and that even if the measurement location is arbitrarily set, it is not contrived.

### (Average composition of stack structure)

The average composition of a stack structure can be obtained by calculating the average composition of a region in which the line analysis has been carried out, based on the results of the line analysis in (A5) above.

The average of {Asi/(Asi + A_{M})} × 100 in the region in which the line analysis has been carried out is preferably 1% or more and 8% or less, more preferably 1.5% or more and 7.5% or less, and more preferably 2% or more and 5% or less, from the viewpoint of improving the heat resistance.

As used herein, the average of {Asi/(Asi + A_{M})} × 100 means the average of the values obtained by carrying out line analysis on three adjacent hard particles.

### (Crystal orientation of each of first unit layer and second unit layer)

The first unit layer and the second unit layer preferably have the same crystal orientation. According to this, the interfacial energy can be suppressed. Examples of the crystal orientation include {311}, {211}, {110}, {100}, and {111}. In a crystallographic description herein, {} represents a family of planes.

It is confirmed by the following procedure that the first unit layer and the second unit layer have the same crystal orientation. An electron diffraction image as shown in Fig. 6 is obtained by the same method as in (A1) to (A4) above. When the electron diffraction image is a diffraction image from a single crystal, it is determined that the first unit layer and the second unit layer have the same crystal orientation.

### (Period width of stack structure)

The average of the period width of the stack structure in the present embodiment is preferably 2 nm or more and 20 nm or less, preferably 4.1 nm or more and 17.7 nm or less, preferably 3 nm or more and 15 nm or less, and preferably 5 nm or more and 10 nm or less, from the viewpoint of maintaining the strain between the unit layers and improving the breakage resistance. Here, the term period width of the stack structure refers to the distance from one first unit layer to another adjacent first unit layer with a second unit layer adjacent to the one first unit layer interposed therebetween. This distance is a distance connecting the midpoint in the thickness direction of the first unit layer and the midpoint in the thickness direction of another first unit layer. The term average of the period width of the stack structure means the average of the period widths of all stack structures measured in the measurement region set in (A3) above.

Herein, the method for measuring the period width of the concentration of silicon is as follows. A measurement region is set by the same method as in (A1) to (A3) above. A Fourier transform is carried out on the measurement region to obtain a Fourier transform image. A Fourier transform image obtained by carrying out a Fourier transform on region A shown in Fig. 5 is shown in Fig. 8. In the Fourier transform image, the periodicity within the measurement region appears as a spot. The period width is calculated by calculating the reciprocal of the distance between the spot and the center of the image showing the maximum intensity in the Fourier transform image.

It has been confirmed that as long as the measurement is carried out on the same sample, even if the measurement is carried out a plurality of times by changing the measurement location, there is little variation in the measurement results, and that even if the measurement location is arbitrarily set, it is not contrived.

The number of stacked layers (total number of stacked layers) of the first unit layer and the second unit layer that constitute a multilayer structure layer is not particularly limited, and is, for example, preferably 10 layers or more and 1000 layers or less. When the number of stacked layers is 10 layers or more, coarsening of a crystal grain in each unit layer is suppressed, and the hardness of the hard particle can be maintained. On the other hand, when the number of stacked layers is 1000 layers or less, the thickness of each unit layer can be sufficiently secured, and mixing of the unit layers can be suppressed.

### <Base layer>

Preferably, the coating comprises a base layer disposed between the base material and the hard particle layer, the base layer is formed from a third compound, and the third compound consists of
one or more elements selected from the group consisting of a periodic table group 4 element, a periodic table group 5 element, a periodic table group 6 element, and aluminum, and
one or more elements selected from the group consisting of carbon, nitrogen, boron, and oxygen.

According to this, the close adhesion between the coating and the base material is improved, and the wear resistance is also improved.

By disposing a TiN layer, a TiC layer, a TiCN layer, or a TiBN layer directly on the base material as the base layer, the close adhesion between the base material and the coating can be enhanced. By using an Al₂O₃ layer as the base layer, the oxidation resistance of the coating can be enhanced. The base layer preferably has an average thickness of 0.1 µm or more and 20 µm or less. According to this, the coating can have excellent wear resistance and breakage resistance.

### <Surface layer>

Preferably, the coating comprises a surface layer disposed on a topmost surface thereof, the surface layer is formed from a fourth compound, and the fourth compound consists of
one or more elements selected from the group consisting of a periodic table group 4 element, a periodic table group 5 element, a periodic table group 6 element, and aluminum, and
one or more elements selected from the group consisting of carbon, nitrogen, boron, and oxygen. According to this, the thermal crack resistance and the wear resistance of the coating are improved.

The surface layer is a layer disposed closest to the surface of the coating. However, no surface layer may be formed at a cutting edge ridgeline portion. The surface layer is disposed directly on the hard particle layer when no different layer is formed on the hard particle layer.

Examples of the surface layer include a TiN layer or an Al₂O₃ layer. The TiN layer has a clear color (exhibits a gold color) and thus the use thereof as the surface layer has the advantage of easy identification of a corner of the cutting insert after used for cutting (identification of a used site). By using an Al₂O₃ layer as the surface layer, the oxidation resistance of the coating can be enhanced.

The surface layer preferably has an average thickness of 0.05 µm or more and 1 µm or less. According to this, the close adhesion between the surface layer and an adjacent layer is improved.

### <Intermediate layer>

The intermediate layer is a layer disposed between the base layer and the hard particle layer. When the base layer is a TiN layer, the intermediate layer is preferably a TiCN layer. The TiCN layer has excellent wear resistance, and thus can impart more suitable wear resistance to the coating. The intermediate layer preferably has an average thickness of 1 µm or more and 20 µm or less.

### [Embodiment 2: Method for Manufacturing Cutting Tool]

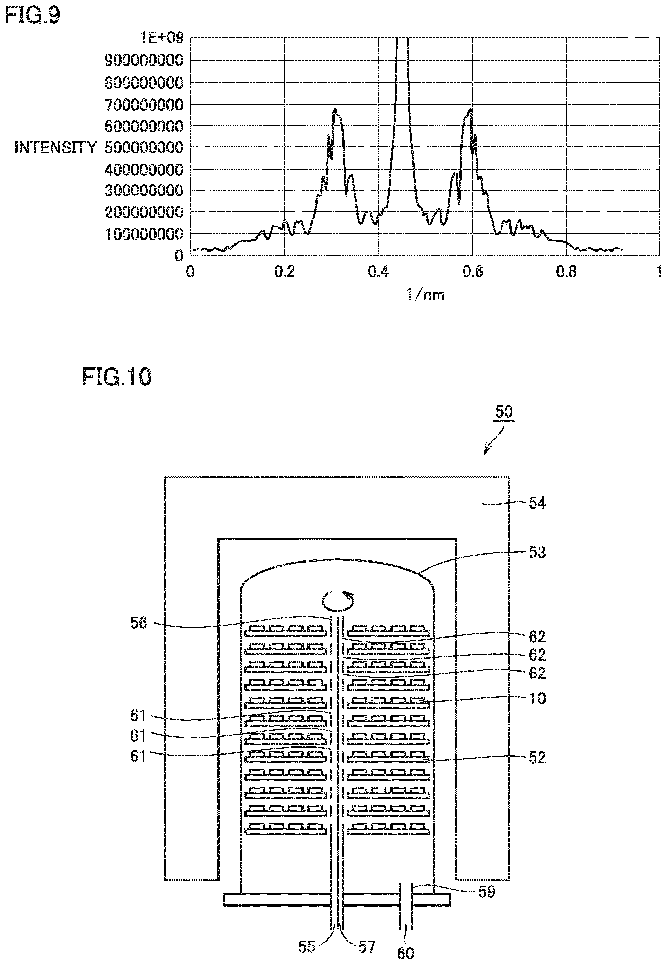

A method for manufacturing the cutting tool of the present embodiment will be described with reference to Fig. 10. Fig. 10 is a schematic cross-sectional view of one example of a CVD apparatus used for manufacturing the cutting tool of the present embodiment.

The method for manufacturing the cutting tool of the present embodiment is a method for manufacturing the cutting tool of Embodiment 1, the method comprising a first step of preparing a base material, and
a second step of forming a coating on the base material to obtain a cutting tool, wherein the second step comprises a 2a-th step of forming a hard particle layer formed from a hard particle by a CVD method,
the 2a-th step comprises a 2a-1-th step of ejecting a first raw material gas, a second raw material gas, and a third raw material gas toward a surface of the base material,
the first raw material gas comprises one or more elements selected from the group consisting of a periodic table group 4 element, a periodic table group 5 element, and a periodic table group 6 element,
the second raw material gas is SiCl₄,
the third raw material gas comprises one or more elements selected from the group consisting of carbon, nitrogen, boron, and oxygen,
the first raw material gas is ejected from a plurality of first jet holes provided in a nozzle,
the second raw material gas is ejected from a plurality of second jet holes provided in the nozzle,
the third raw material gas is ejected from a plurality of third jet holes provided in the nozzle,
in the 2a-1-th step, the nozzle rotates,
the plurality of second jet holes comprise a 2-1-th jet hole and a 2-2-th jet hole, and
a diameter r1 of the 2-1-th jet hole is different from a diameter r2 of the 2-2-th jet hole.

### (First step)

In the first step, a base material is prepared. Details of the base material have been described in Embodiment 1, and thus the description thereof will not be repeated.

### (Second step)

Next, in the second step, a coating is formed on the base material to obtain a cutting tool. The coating is formed by using, for example, the CVD apparatus shown in Fig. 10. A plurality of base material setting jigs 52 holding base materials 10 can be installed in a CVD apparatus 50, and these are covered with a reaction vessel 53 made of a heat-resistant alloy steel. In addition, a temperature control apparatus 54 is disposed around reaction container 53, and the temperature in reaction container 53 can be controlled by temperature control apparatus 54.

A nozzle 56 having three introduction ports 55 and 57 (the remaining one introduction port is not shown) is disposed in CVD apparatus 50. Nozzle 56 is disposed in such a way as to pass through a region in which base material setting jigs 52 are disposed. A plurality of jet holes (first jet holes 61, second jet holes 62, third jet holes (not shown)) are formed in a portion in the vicinity of base material setting jigs 52 of nozzle 56.

In Fig. 10, the gases introduced into nozzle 56 from introduction ports 55, 57, and the remaining one introduction port (not shown) are introduced into reaction vessel 53 through different jet holes, respectively, without being mixed in nozzle 56. This nozzle 56 can rotate around the axis thereof as a central axis. In addition, an exhaust pipe 59 is disposed in CVD apparatus 50, and the exhaust gas can be discharged to the outside from an exhaust port 60 of exhaust pipe 59. The jigs and the like in reaction vessel 53 are usually constituted by graphite.

When the coating includes a base layer, an intermediate layer, and/or a surface layer, these layers can be formed by a conventionally known method.

### (2a-th step)

The second step includes a 2a-th step of forming a hard particle layer formed from a hard particle by a CVD method, and the 2a-th step includes a 2a-1-th step of ejecting a first raw material gas, a second raw material gas, and a third raw material gas toward a surface of the base material.

The first raw material gas includes one or more elements selected from the group consisting of a periodic table group 4 element, a periodic table group 5 element, and a periodic table group 6 element. The first raw material gas is, for example, a chloride gas of a periodic table group 4 element, a periodic table group 5 element, or a periodic table group 6 element. More specific examples thereof include TiCl₄, ZrCl₄, VCl₄, CrCl₃, and a mixed gas including two or more of these. The second raw material gas is SiCl₄. The third raw material gas is, for example, CH₃CN, CH₄, N₂, NH₃, BCl₃, H₂O, or a mixed gas including two or more of these

The first raw material gas is ejected from a plurality of first jet holes provided in a nozzle, the second raw material gas is ejected from a plurality of second jet holes provided in the nozzle, and the third raw material gas is ejected from a plurality of third jet holes provided in the nozzle. Specifically, the first raw material gas is introduced into nozzle 56 from introduction port 55 of the nozzle and ejected from the plurality of first jet holes 61. The second raw material gas is introduced into nozzle 56 from introduction port 57 of the nozzle and ejected from the plurality of second jet holes 62. The third raw material gas is introduced into nozzle 56 from an introduction port (not shown) of the nozzle and ejected from the plurality of third jet holes (not shown).

In the 2a-1-th step, the nozzle rotates, the plurality of second jet holes includes a 2-1-th jet hole and a 2-2-th jet hole, and the diameter r1 of the 2-1-th jet hole is different from the diameter r2 of the 2-2-th jet hole. According to this, the hard particle can include a multilayer structure including a first unit layer and a second unit layer, wherein the percentage of the number of atoms of silicon to the sum of the numbers of atoms of the metal element and silicon in the first unit layer is different from the percentage of the number of atoms of silicon to the sum of the numbers of atoms of the metal element and silicon in the second unit layer. In the following description, r1 < r2 is assumed in order to facilitate understanding.

The diameter r1 of the 2-1-th jet hole is preferably 0.5 mm or more and 3 mm or less, more preferably 1 mm or more and 2.5 mm or less, and further preferably 1.5 mm or more and 2 mm or less. The diameter r2 of the 2-2-th jet hole is preferably 1 mm or more and 4 mm or less, more preferably 1.5 mm or more and 3.5 mm or less, and further preferably 2 mm or more and 3 mm or less.

The lower limit of the ratio r1/r2 between the diameter r1 of the 2-1-th jet hole and the diameter r2 of the 2-2-th jet hole is preferably 0.125 or more, more preferably 0.2 or more, and further preferably 0.5 or more. The upper limit of r1/r2 is preferably less than 1, preferably 0.8 or less, and preferably 0.6 or less. r1/r2 is preferably 0.125 or more and less than 1, preferably 0.2 or more and 0.8 or less, and preferably 0.5 or more and 0.6 or less.

In the present step, the base material temperature in the reaction vessel is preferably in the range of 700 to 900°C, and the pressure in the reaction vessel is preferably in the range of 0.1 to 13 kPa. In addition, H₂ gas, N₂ gas, Ar gas, or the like can be used as a carrier gas. The composition of each of the first unit layer and the second unit layer can be controlled by the mixing proportions of the raw material gases and the ratio r1/r2 between the diameter r1 of the 2-1-th jet hole and the diameter r2 of the 2-2-th jet hole. The thickness of the hard particle layer can be controlled by regulating the flow rates of the raw material gases and the film formation time. The thickness of each of the first unit layer and the second unit layer, the stack period thereof, and the number of stacked layers thereof can be controlled by regulating the rotation speed of the nozzle and the film formation time.

The total gas flow rate of the reaction gas during the formation of the hard particle layer can be, for example, 70 to 90 L/min. Here, the term "total gas flow rate" refers to the total volume flow rate introduced into a CVD furnace per unit time, assuming that a gas under the standard conditions (0°C, 1 atm) is an ideal gas.

### (Other steps)

Next, base material 10 with a coating formed thereon is cooled. The cooling rate does not exceed, for example, 5°C/min, and the cooling rate slows as the temperature of base material 10 decreases.

In addition to the above steps, a heat treatment step such as annealing or a surface treatment step such as surface grinding or shot blasting can be carried out.

The cutting tool of Embodiment 1 can be obtained by the manufacturing method described above.

### Examples

The present embodiment will be described more specifically with reference to Examples. However, the present embodiment is not limited by these Examples.

### <Preparation of Base Material (First step)>

Base material A shown in Table 1 below was prepared. Specifically, first, raw material powders having the blending compositions (% by mass) shown in Table 1 were uniformly mixed to obtain mixed powders, respectively. "Balance" in Table 1 shows that WC accounts for the balance of the blending composition (% by mass). Next, the mixed powders were pressure-molded into the shape of SEMT13T3AGSR-G (indexable cutting insert manufactured by Sumitomo Electric Hardmetal Corp.), and then sintered at 1300 to 1500°C for 1 to 2 hours to obtain base material A made of a cemented carbide. Base material A has a base material shape of SEMT13T3AGSR-G.

### [Table 1]

**Table 1**

| Type | Blending composition (% by mass) | | | |
|---|---|---|---|---|
| | Co | NbC | TaC | WC |
| Base material A | 10 | 0.1 | 2 | Balance |

### <Formation of Coating (Second step)>

A coating was formed on the surface of base material A obtained above. Specifically, by using the CVD apparatus shown in Fig. 10, the base material was set in base material setting jigs, and a thermal CVD method was carried out to form a coating on the base material. The configuration of the coating of each sample is shown in Table 2. In addition, a cell shown by "-" in Table 2 means that no layer is present.

### [Table 2]

**Table 2**

| Sample No. | Type of base material | Configuration of coating and thickness of each layer | | | | Thickness of entire coating (µm) |
|---|---|---|---|---|---|---|
| | | Base layer | Intermediate layer | Hard particle layer | Surface layer | |
| | | TiN (µm) | TiCN (µm) | Film formation condition (thickness (µm)) | Al₂O₃ (µm) | |
| 1 | A | 1.0 | 2.2 | A(4.5) | - | 7.7 |
| 2 | A | 0.9 | 1.9 | B(5.1) | - | 7.9 |
| 3 | A | 1.1 | 1.8 | C(4.9) | - | 7.8 |
| 4 | A | 1.2 | 1.7 | D(4.5) | - | 7.4 |
| 5 | A | 1.0 | 1.8 | E(4.0) | - | 6.8 |
| 6 | A | 0.9 | 2.0 | F(4.7) | - | 7.6 |
| 7 | A | 1.1 | 2.3 | G(4.2) | - | 7.6 |
| 8 | A | - | - | A(7.0) | - | 7.0 |
| 9 | A | - | - | A(3.0) | - | 3.0 |
| 10 | A | 1.0 | 4.5 | A(15.0) | 9.5 | 30.0 |
| 11 | A | 1.5 | - | A(9.7) | 1.5 | 12.2 |
| 12 | A | 1.8 | - | D(10.7) | - | 12.5 |
| 13 | A | 1.8 | - | E(8.9) | 1.0 | 11.7 |
| 14 | A | 1.5 | - | F(11.3) | - | 12.8 |
| 15 | A | 1.7 | - | G(9.9) | - | 11.6 |
| 16 | A | - | - | B(10.5) | - | 10.5 |
| 1-1 | A | 1.1 | 2.0 | X(4.7) | - | 7.8 |
| 1-2 | A | 1.5 | - | X(11.5) | - | 13.0 |
| 1-3 | A | - | - | Y(7.5) | - | 7.5 |
| 1-4 | A | - | - | Y(13.0) | - | 13.0 |

The base layer (TiN layer), the intermediate layer (TiCN layer), and the surface layer (Al₂O₃ layer) shown in Table 2 are layers formed by a conventionally known CVD method, and the film formation conditions therefor are as shown in Table 3. For example, the row of "TiN (base layer)" in Table 3 shows the film formation conditions for a TiN layer as the base layer. The description of TiN (base layer) in Table 3 means that a base material is disposed in a reaction vessel of the CVD apparatus (pressure in reaction vessel of 6.7 kPa, base material temperature of 915°C), and a mixed gas consisting of 2.0% by volume of TiCl₄ gas, 39.7% by volume of N₂ gas, and a balance (58.3% by volume) of H₂ gas is ejected at a flow rate of 63.8 L/min into the reaction vessel to form the TiN layer. The thickness of each layer formed under the film formation conditions therefor was controlled by the time during which each reaction gas was ejected.

### [Table 3]

**Table 3**

| Configuration of coating | Film formation conditions | Reaction atmosphere | | |
|---|---|---|---|---|
| Composition | Reaction gas composition (% by volume) | Pressure in reaction vessel (kPa) | Base material temperature (°C) | Total gas flow rate (L/min) |
| TiN (base layer) | TiCl₄ = 2.0, N₂ = 39.7, H₂ = balance | 6.7 | 915 | 63.8 |
| TiN (outermost layer) | TiCl₄ = 0.5, N₂ = 41.2, H₂ = balance | 79.8 | 980 | 45.9 |
| TiCN | TiCl₄ = 2.0, CH₃CN = 0.7, H₂ = balance | 9.0 | 860 | 50.5 |
| TiCNO | TiCl₄ = 2.1, CO = 3.2, CH₄ = 2.8, N₂ = 23.7, H₂ = balance | 16.0 | 1030 | 70.5 |
| Al₂O₃ | AlCl₃ = 1.6, CO₂ = 4.5, H₂S = 0.2, HCl = 3.5, H₂ = balance | 6.7 | 1000 | 46.2 |

Film formation conditions A to G, X, and Y in the hard particle layer column of Table 2 correspond to film formation conditions A to G of Table 4 and film formation conditions X and Y of Table 5, respectively. For example, the row of "Sample No. 1" in Table 2 shows that the hard particle layer of sample 1 is a layer formed under film formation condition A in Table 4, and the numerical value in parentheses means that the thickness of the hard particle layer is 4.5 µm.

### [Table 4]

**Table 4**

| Film formation condition | | A | B | C | D | E | F | G |
|---|---|---|---|---|---|---|---|---|
| Film formation method | | CVD | CVD | CVD | CVD | CVD | CVD | CVD |
| Temperature (°C) | | 800 | 800 | 800 | 850 | 850 | 800 | 800 |
| Pressure (kPa) | | 9.0 | 9.0 | 9.0 | 6.5 | 9.0 | 9.0 | 9.0 |
| Reaction gas composition (% by volume) | SiCl₄ | 1 | 1 | 1 | 0.5 | 0.7 | 0.7 | 0.7 |
| | TiCl₄ | 1 | 1 | 1 | 1.5 | 1.0 | 1.0 | 1.0 |
| | ZrCl₄ | - | - | - | - | 0.2 | - | - |
| | VCl₄ | - | - | - | - | - | 0.2 | - |
| | CrCl₃ | - | - | - | - | - | - | 0.1 |
| | CH₃CN | 0.5 | 0.5 | 0.5 | 0.5 | 0.3 | 0.3 | 0.4 |
| | BCl₃ | - | - | - | 0.005 | - | - | - |
| | H₂ | Balance | Balance | Balance | Balance | Balance | Balance | Balance |
| Jet hole diameter ϕ (mm) r1/r2 | | 1.5/2.5 | 1.5/2.5 | 2.0/4.0 | 1.5/2.5 | 1.5/2.5 | 1.5/2.5 | 1.5/2.5 |
| Rotation speed (rpm) | | 2.0 | 10.0 | 1.0 | 2.0 | 2.0 | 2.0 | 2.0 |

### (Film formation condition A to film formation condition G)

Under film formation condition A to film formation condition G, a hard particle layer is formed by using the CVD apparatus shown in Fig. 10. First jet holes, second jet holes (2-1-th jet hole and 2-2-th jet hole), and third jet holes are provided in the nozzle of the CVD apparatus. The diameter ϕr1 of the 2-1-th jet hole and the diameter cpr2 of the 2-2-th jet hole in the nozzle of the CVD apparatus used under each film formation condition are shown in the "Jet hole diameter ϕ (mm) r1/r2" column in Table 4. For example, under film formation condition A, the diameter ϕr1 of the 2-1-th jet hole is 1.5 mm, and the diameter cpr2 of the 2-2-th jet hole is 2.5 mm. The nozzle rotates during film formation.

Under film formation condition A to film formation condition G, first, the pressure in the reaction vessel of the CVD apparatus is set to the pressure shown in the "Pressure (kPa)" column of Table 4, and the base material temperature is set to the temperature shown in the "Temperature (°C)" column of Table 4. For example, under film formation condition A, the pressure in the reaction vessel of the CVD apparatus is set to 9.0 kPa, and the base material temperature is set to 800°C.

Next, a reaction gas including the components shown in the "Reaction gas composition (% by volume)" column of Table 4 is introduced into the reaction vessel to form a hard particle layer on the base material. "Balance" in Table 4 shows that H₂ gas accounts for the balance of the reaction gas composition (% by volume). Among the reaction gases, TiCl₄, ZrCl₄, VCl₄, and CrCl₃ are the first raw material gases, SiCl₄ is the second raw material gas, and CH₃CN and BCl₃ are the third raw material gases H₂ is mixed into the third raw material gas in order to adjust the total gas flow rate.

Under formation condition A to formation condition G, the total gas flow rate of the reaction gases is 80 L/min. The term "total gas flow rate" refers to the total volume flow rate introduced into a CVD furnace per unit time, assuming that a gas under the standard conditions (0°C, 1 atm) is an ideal gas. For example, the reaction gas used under film formation condition A consists of 1% by volume of SiCl₄ gas, 1% by volume of TiCl₄ gas, 0.5% by volume of CH₃CH gas, and H₂ gas (balance, 97.5% by volume).

The rotation speed of the nozzle during film formation is as shown in the "Rotation speed (rpm)" column of Table 4. For example, under film formation condition A, the rotation speed of the nozzle is 2.0 rpm.

After that, the base material is cooled.

### (Film formation condition X)

Under film formation condition X, the hard particle layer is formed by using a conventional CVD apparatus. All the jet holes of the nozzle of the CVD apparatus have the same diameter ϕ of 10 mm. The nozzle does not rotate during film formation.

Under film formation condition X, first, the pressure in the reaction vessel of the CVD apparatus is set to 6 kPa, and the base material temperature is set to 800°C.

Next, a reaction gas including the components shown in the "Reaction gas composition (% by volume)" column of Table 5 (SiCl₄: 0.84% by volume, TiCl₄: 0.17% by volume, CH₃CN: 0.32% by volume, H₂: the balance) is introduced into the reaction vessel to form a TiSiCN layer (hard particle layer) on the base material. The total gas flow rate of the reaction gas is 80 L/min. After that, the base material is cooled.

### (Film formation condition Y)

Under film formation conditions Y, a hard particle layer is formed by a conventional PVD method. Specific conditions of film formation condition Y are as shown in the column of "Film formation condition Y" in Table 5.

According to the above, cutting tools of sample 1 to sample 16 (corresponding to Examples) and sample 1-1 to sample 1-4 (corresponding to Comparative Examples) were obtained.

### [Table 5]

**Table 5**

| Film formation condition | | X | Film formation condition | Y |
|---|---|---|---|---|
| Formation method | | Conventional CVD | Formation method | Conventional PVD |
| Temperature (°C) | | 800 | Temperature (°C) | 500 |
| Pressure (kPa) | | 6 | Pressure (kPa) | 0.03 |
| Reaction gas composition (% by volume) | SiCl₄ | 0.84 | Target metal composition | Ti/Si=80/20 |
| | TiCl₄ | 0.17 | Arc current (A) | 150 |
| | ZrCl₄ | - | Bias voltage (V) | -200 |
| | VCl₄ | - | N₂/CH₄ gas ratio | 1/1 |
| | CrCl₃ | - | | |
| | CH₃CN | 0.32 | | |
| | BCl₃ | - | | |
| | H₂ | Balance | | |
| Nozzle diameter ϕ (mm) | | 10 | | |
| Rotation speed (rpm) | | - | | |

### <Characteristics of Hard Particle Layer>

### (Structure of Hard Particle Layer)

When the hard particle layer of the coating obtained under each of film formation condition A to film formation condition G was observed with a bright-field scanning electron microscope (BF-SEM), it was confirmed that the hard particle layer was formed from a plurality of hard particles, and a multilayer structure was confirmed in the hard particles. It was confirmed that the multilayer structure of the hard particle layer obtained under each of film formation condition A to film formation condition G was formed by a layer having a large percentage of the number of atoms of silicon to the sum of the numbers of atoms of the metal element and silicon (first unit layer), and a layer having a small percentage of the number of atoms of silicon to the sum of the numbers of atoms of the metal element and silicon (second unit layer) that were alternately stacked.

It was confirmed that the first unit layer and the second unit layer in the hard particle layer obtained under each of film formation condition A to film formation condition G had the same crystal orientation.

When the hard particle (TiCN) layer obtained under formation condition X was observed with a bright-field scanning electron microscope (BF-SEM), the layer had a uniform structure, and no periodic change was confirmed.

When the hard particle layers obtained under formation condition Y were observed with a bright-field scanning electron microscope (BF-SEM), a nanocomposite structure was confirmed.

(Average composition of stack structure, {Asi/(Asi + A_{M})} × 100 (%) in first unit layer, and {Asi/(Asi + A_{M})} × 100 (%) in second unit layer)

For the hard particle layer obtained under each film formation condition, the average composition of the stack structure, the percentage of the number of atoms of silicon to the sum of the numbers of atoms of the metal element and silicon in the first unit layer (Si/Me + Si (%)), and the percentage of the number of atoms of silicon to the sum of the numbers of atoms of the metal element and silicon ({A_{Si}/(A_{Si} + A_{M})} × 100 (%)) in the second unit layer were measured. A specific measurement method is as described in Embodiment 1, and thus the description thereof will not be repeated. Results thereof are shown in the "Average composition," "First unit layer {Asi/(Asi + A_{M})} × 100 (%)," and "Second unit layer {Asi/(Asi + A_{M})} × 100 (%)" columns of Table 6. The notation of "-" shows that no measurement was carried out.

### (Period width)

For the hard particle layer obtained under each film formation condition, the average of the period width of the multilayer structure was measured. A specific measurement method is as described in Embodiment 1, and thus the description thereof will not be repeated. Results thereof are shown in the "Average of period width (nm)" column of Table 6. The notation of "-" shows that no measurement was carried out.

### [Table 6]

**Table 6**

| Film formation condition | A | B | C | D |
|---|---|---|---|---|
| Average composition | Ti_{0.93}Si_{0.07}C_{0.55}N_{0 .45} | Ti_{0.94}Si_{0.06}C_{0.55}N_{0 .45} | Ti_{0.90}Si_{0.10}C_{0.55}N_{0. 45} | Ti_{0.97}Si_{0.03}C_{0.54}N_{0 .44}B_{0.02} |
| First unit layer {A_{Si}/(A_{Si}+A_{M}))×100 (%) | 10.0 | 6.0 | 8.0 | 6.4 |
| Second unit layer {A_{Si}/(A_{Si}+A_{M}))×100 (%) | 2.0 | 2.0 | 1.5 | 1.2 |
| Average period width (nm) | 7.1 | 4.1 | 17.7 | 5.5 |
| Film formation condition | E | F | G | X |
| Average composition | Ti_{0.9}Zr_{0.07}Si_{0.03}C_{0 .56}N_{0.44} | Ti_{0.89}V_{0.08}Si_{0.03}C_{0 .57}N_{0.43} | Ti_{0.90}Cr_{0.08}Si_{0.02}C_{0 .53}N_{0.47} | Ti_{0.80}Si_{0.20}C_{0.57}N_{0 .43} |
| First unit layer {A_{Si}/(A_{Si}+A_{M}))×100 (%) | 6.5 | 7.2 | 5.3 | - |
| Second unit layer {A_{Si}/(A_{Si}+A_{M})}×100 (%) | 1.3 | 1.5 | 0.5 | - |
| Average period width (nm) | 6.2 | 7.9 | 8.3 | - |

### <Cutting test 1>

By using each of the cutting tools of sample 1 to sample 10 and sample 1-1 and sample 1-3, cutting was carried out under the following cutting conditions to measure the cutting distance until the cutting edge of the tool reached a state of breakage. The following cutting conditions correspond to milling working (dry working) of high-hardness and heat-resistant stainless steel. A longer cutting distance shows a longer tool life. Results thereof are shown in Table 7.

### <Cutting conditions>

Work material: SUS630/H900 block material (dimensions: 300 mm × 150 mm × 50 mm)
Cutter: WGX13100RS (manufactured by Sumitomo Electric Hardmetal Corp.)
Insert: SEMT13T3AGSR-G
Cutting speed Vc: 300 m/min
Feed per cutting edge Fz: 0.1 mm/t
Cutting depth Ap: 1.0 mm
Cutting width Ae: 75 mm
Cutting fluid: No (Dry)

### [Table 7]

**Table 7**

| Sample No. | Cutting distance (m) |
|---|---|
| 1 | 30 |
| 2 | 42 |
| 3 | 20 |
| 4 | 33 |
| 5 | 35 |
| 6 | 23 |
| 7 | 38 |
| 8 | 18 |
| 9 | 20 |
| 10 | 15 |
| 1-1 | 15 |
| 1-3 | 10 |

### (Evaluation 1)

It was confirmed that sample 1 to sample 10 (Examples) had a longer cutting distance and a longer tool life than sample 1-1 and sample 1-3 (Comparative Examples) in milling working (dry working) of high-hardness and heat-resistant stainless steel. It is presumed that this is because in sample 1 to sample 10, the hard particle included a multilayer structure and thus the thermal crack propagation resistance and the peeling resistance were improved.

### <Cutting test 2>

By using each of the cutting tools of sample 11 to sample 16 and sample 1-2 and sample 1-4, cutting was carried out under the following cutting conditions to measure the cutting distance until the cutting edge of the tool reached a state of breakage. The following cutting conditions correspond to milling working (wet working) of high-hardness and heat-resistant stainless steel. A longer cutting time shows better heat resistance and a longer tool life. Results thereof are shown in Table 8.

### <Cutting conditions>

Work material: SUS640/H900 block material (dimensions: 300 mm × 150 mm × 50 mm)
Cutter: WGX13100RS (manufactured by Sumitomo Electric Hardmetal Corp.)
Insert: SEMT13T3AGSR-G
Cutting speed Vc: 150 m/min
Feed per cutting edge fz: 0.3 mm/t
Cutting depth ap: 1.0 mm
Cutting width ae: 75 mm
Cutting fluid: WET

### [Table 8]

**Table 8**

| Sample No. | Cutting distance (m) |
|---|---|
| 11 | 23 |
| 12 | 18 |
| 13 | 17 |
| 14 | 18 |
| 15 | 15 |
| 16 | 14 |
| 1-2 | 5 |
| 1-4 | 13 |

### (Evaluation 2)

It was confirmed that sample 11 to sample 16 (Examples) had a longer cutting distance and a longer tool life than sample 1-2 and sample 1-4 (Comparative Examples) in milling working (wet working) of high-hardness and heat-resistant stainless steel. It is presumed that this is because in sample 11 to sample 16, the hard particle included a multilayer structure and thus the thermal crack propagation resistance and the peeling resistance were improved.

The embodiments and Examples of the present disclosure have been described as above, and it is also planned from the beginning to appropriately combine the configurations of the embodiments and Examples described above and to modify these in various ways.

The embodiments and the Examples disclosed this time should be considered to be illustrative in all respects and non-limiting. The scope of the present invention is defined by the Claims, not by the above embodiments and Examples, and is intended to include all modifications within the meaning and scope equivalent to the Claims.

### REFERENCE SIGNS LIST

1, 21, 31, 41 Cutting tool, 10 Base material, 11 Hard particle layer, 12 Base layer, 13 Surface layer, 14 Intermediate layer, 15, 25, 35, 45 Coating, 50 CVD apparatus, 52 Base material setting jig, 53 Reaction vessel, 54 Temperature control apparatus, 55, 57 Introduction port, 56 Nozzle, 59 Exhaust pipe, 60 Exhaust port, 61 First jet hole, 62 Second jet hole.

## Claims

1. A cutting tool comprising a base material and a coating disposed on the base material, wherein
the coating comprises a hard particle layer formed from a hard particle,
the hard particle comprises a multilayer structure in which a first unit layer and a second unit layer are alternately stacked,
the first unit layer is formed from a first compound having a cubic crystal structure, the second unit layer is formed from a second compound having a cubic crystal structure,
each of the first compound and the second compound consists of
one or more metal elements selected from the group consisting of a periodic table group 4 element, a periodic table group 5 element, and a periodic table group 6 element,
silicon, and
one or more elements selected from the group consisting of carbon, nitrogen, boron, and oxygen, and
a percentage of the number of atoms of the silicon to a sum of the numbers of atoms of the metal element and the silicon in the first unit layer is different from a percentage of the number of atoms of the silicon to a sum of the numbers of atoms of the metal element and the silicon in the second unit layer.

2. The cutting tool according to claim 1, wherein the first unit layer and the second unit layer have the same crystal orientation.

3. The cutting tool according to claim 1 or claim 2, wherein in each of the first unit layer and the second unit layer, the percentage of the number of atoms of the silicon to the sum of the numbers of atoms of the metal element and the silicon is 0.5% or more and 10% or less.

4. The cutting tool according to any one of claim 1 to claim 3, wherein a thickness of the hard particle layer is 3 µm or more and 15 µm or less, and
a thickness of the coating is 3 µm or more and 30 µm or less.

5. The cutting tool according to any one of claim 1 to claim 4, wherein a difference between the percentage of the number of atoms of the silicon, A_{Si}, to the sum of the number of atoms of the metal element, A_{M}, and the number of atoms of the silicon, A_{Si}, {Asi/(Asi + A_{M})} × 100, in the first unit layer and the percentage of the number of atoms of the silicon, A_{Si}, to the sum of the number of atoms of the metal element, A_{M}, and the number of atoms of the silicon, A_{Si}, {Asi/(Asi + A_{M})} × 100, in the second unit layer is 0.5% or more and 10% or less.

6. The cutting tool according to any one of claim 1 to claim 4, wherein the coating comprises a base layer disposed between the base material and the hard particle layer,
the base layer is formed from a third compound, and
the third compound consists of
one or more elements selected from the group consisting of a periodic table group 4 element, a periodic table group 5 element, a periodic table group 6 element, and aluminum, and
one or more elements selected from the group consisting of carbon, nitrogen, boron, and oxygen.

7. The cutting tool according to any one of claim 1 to claim 5, wherein
the coating comprises a base layer disposed directly on the base material, and
the base layer consists of at least one selected from the group consisting of a TiN layer, a TiC layer, a TiCN layer, a TiBN layer, and an Al₂O₃ layer.

8. The cutting tool according to any one of claim 1 to claim 7, wherein the coating comprises a surface layer disposed on a topmost surface thereof,
the surface layer is formed from a fourth compound, and
the fourth compound consists of
one or more elements selected from the group consisting of a periodic table group 4 element, a periodic table group 5 element, a periodic table group 6 element, and aluminum, and
one or more elements selected from the group consisting of carbon, nitrogen, boron, and oxygen.

9. The cutting tool according to claim 6 or claim 7, wherein the coating comprises an intermediate layer disposed between the base layer and the hard particle.

10. A method for manufacturing the cutting tool according to any one of claim 1 to claim 9, the method comprising
a first step of preparing a base material, and
a second step of forming a coating on the base material to obtain a cutting tool, wherein the second step comprises a 2a-th step of forming a hard particle layer formed from a hard particle by a CVD method,
the 2a-th step comprises a 2a-1-th step of ejecting a first raw material gas, a second raw material gas, and a third raw material gas toward a surface of the base material,
the first raw material gas comprises one or more elements selected from the group consisting of a periodic table group 4 element, a periodic table group 5 element, and a periodic table group 6 element,
the second raw material gas is SiCl₄,
the third raw material gas comprises one or more elements selected from the group consisting of carbon, nitrogen, boron, and oxygen,
the first raw material gas is ejected from a plurality of first jet holes provided in a nozzle,
the second raw material gas is ejected from a plurality of second jet holes provided in the nozzle,
the third raw material gas is ejected from a plurality of third jet holes provided in the nozzle,
in the 2a-1-th step, the nozzle rotates,
the plurality of second jet holes comprise a 2-1-th jet hole and a 2-2-th jet hole, and
a diameter r1 of the 2-1-th jet hole is different from a diameter r2 of the 2-2-th jet hole.
